# EUROPEAN PATENT SPECIFICATION

(11) **EP 4 078 684 B1**
(45) Date of publication and mention of the grant of the patent: **04.10.2023**
(21) Application number: 20830376.8
(22) Date of filing: 18.12.2020
(51) Int. Cl.: H01L 31/0232, H01L 31/0463, H01L 31/0468, H01L 31/054

(54) **SEMI-TRANSLUCENT PHOTOVOLTAIC DEVICE AND METHOD OF MANUFACTURING THE SAME**
HALBDURCHSICHTIGE FOTOVOLTAISCHE VORRICHTUNG UND VERFAHREN ZUR HERSTELLUNG
DISPOSITIF PHOTOVOLTAÏQUE SEMI-TRANSPARENT ET PROCÉDÉ DE FABRICATION

(30) Priority: 19.12.2019 EP 19218198
(43) Date of publication of application: 26.10.2022
(73) Proprietor: Nederlandse Organisatie voor toegepast-natuurwetenschappelijk Onderzoek TNO, 2595 DA 's-Gravenhage (NL)
(72) Inventor: LIFKA, Herbert, 2595 DA 's-Gravenhage (NL); ANDRIESSEN, Hieronymus Antonius Josephus Maria, 2595 DA 's-Gravenhage (NL); GALAGAN, Yulia, 2595 DA 's-Gravenhage (NL); FLEDDERUS, Henri, 2595 DA 's-Gravenhage (NL)
(74) Representative: V.O.
(86) International application number: PCT/NL2020/050810
(87) International publication number: WO 2021/125964

(56) References cited:
- WO-A1-2010/034815
- JP-A- 2011 155 154
- JP-A- 2012 134 241
- KR-A- 20110 078 322
- US-A- 5 254 179
- US-A1- 2010 059 103
- US-A1- 2016 211 396
- US-A1- 2019 334 129

## Description

### BACKGROUND

The present application relates to a semi-translucent photovoltaic device.

The present application further relates to a method of manufacturing a semi-translucent photovoltaic device.

A photovoltaic device typically comprises a photovoltaic stack comprising at least a photovoltaic layer sandwiched between a first electrode and a second electrode. Semi-translucent photovoltaic devices are widely applicable in situations wherein it is desired to moderate the strength of solar radiation and to convert the absorbed solar radiation into electric energy.

Photovoltaic products are known for this purpose wherein the photovoltaic stack is interrupted by a pattern of translucent sections. The photovoltaic stack may be provided for example in the pattern of a comb, wherein the spaces between the teeth of the comb are of a translucent material. Also other patterns may be applied to render stack partially translucent. For example, the photovoltaic stack may be interrupted by mutually distributed circular openings. It has been found that misalignments of individual layers of the photovoltaic stack may be clearly visible as a Moiré effect, which may be very disturbing unless it is specifically desired. One option would be to provide the pattern at a sufficiently large scale at which the Moiré effect is no longer visible. However, this is not a solution in applications, wherein the pattern of translucent sections is to be provided at a smaller scale. Accordingly, there is a need for a method of manufacturing a semi-translucent photovoltaic device that mitigates the risk of a Moiré effect becoming visible with smaller scaled translucent patterns and for a semi-translucent photovoltaic device that can be manufactured with such a method.

It is noted that JP 2012 134241 A discloses a method wherein an adhesive layer is formed on an entire rear surface of a see-through type solar cell module having a photoelectric conversion function. Adhesive parts on photoelectric conversion elements and non adhesive parts on openings between the photoelectric conversion elements are formed on the adhesive layer. Decorations are provided by selectively bonding a foil like or powdery color materials only to the adhesive parts on the photoelectric conversion elements.lt is further noted that US 2019/334129 A1 discloses a method for producing a stack that includes the following steps:
- forming a first layer able to conduct electricity,
- forming a layer of interest on the first layer,
- the layer of interest comprising at least one free volume,
- forming at least one repairing element, each repairing element at least partially filling a free volume, called the free volume of interest, the repairing element comprising at least one insulating layer and leaving free an upper surface of the layer of interest opposite the first layer located outside of the at least one free volume,
- forming a second layer, able to conduct electricity, on the layer of interest, the second layer covering the repairing element and the free surface.

### SUMMARY

In order to address this need, a method of manufacturing a semi-translucent photovoltaic device is provided as claimed in claim 1. Additionally, a semi-translucent photovoltaic device as claimed in claim 5 is provided that can be manufactured with this method.

The method as claimed comprises the following steps.

A substrate is provided having a first side with a photovoltaic stack.

Material is removed from the stack in spatially distributed regions, therewith forming openings within these regions. The openings in the spatially distributed regions may be provided in various ways. According to one option circular openings or openings having another shape are provided. According to another option, elongate openings are formed. Dependent on the application, the photovoltaic stack may remain as one unit. I.e. although the stack is interrupted by the openings, it is still laterally connected. That is to say, for each layer in the stack, a path is available therein between each pair of points in that layer. Alternatively, the stack may be partitioned into mutually separate photovoltaic stack-sections.

After patterning the photovoltaic stack, a protective layer is deposited in a blanket-wise fashion over the substrate with the patterned photovoltaic stack, and subsequently a layer of a radiation curable precursor for a polymer is deposited over the protective layer, also in a blanket-wise fashion so that the radiation curable precursor fills the openings in the spatially distributed regions.

Then the substrate is irradiated from a second side, which is opposite its first side with the patterned photovoltaic stack. The radiation to which the substrate is exposed at its second side protrudes to the layer of the radiation curable precursor in the openings where material is removed from the stack. The radiation is absorbed by the material of the photovoltaic stack outside these regions. Therewith the radiation curable precursor present within, and optionally in front of, the spatially distributed openings is selective cured and converted to a translucent polymer. The radiation curable precursor may for example be a visible light curable adhesive, e.g. an adhesive that is curable with a radiation within a wavelength range for which the substrate is translucent, but which is absorbed for photoelectric conversion by the photovoltaic material.

An uncured remainder of the layer of the radiation curable precursor is then removed with a solvent. The protective layer therewith protects the photovoltaic stack against the solvent.

With this method it is achieved that the pattern formed in the radiation curable precursor is properly aligned with the pattern in the photovoltaic stack.

### BRIEF DESCRIPTION OF THE DRAWINGS

These and other aspects are described in more detail with reference to the drawing. Therein:
FIG. 1 schematically shows an embodiment not according to the presently claimed invention, of a semi-translucent photovoltaic device;
FIG. 2 schematically shows an embodiment not according to the presently claimed invention, of a semi-translucent photovoltaic device in use; furthermore, FIG. 2A and FIG. 2B respectively show in top view a first and a second example of said embodiment not according to the presently claimed invention,;
FIG. 3 schematically shows an application of an embodiment not according to the presently claimed invention, of a semi-translucent photovoltaic device;
FIG. 4A-4E schematically shows an embodiment not according to the presently claimed invention, of manufacturing an embodiment of a semi-translucent photovoltaic device not according to the presently claimed invention,;
FIG. 5A-5C schematically shows steps in another embodiment not according to the presently claimed invention, of manufacturing an embodiment not according to the presently claimed invention, of a semi-translucent photovoltaic device;
FIG. 6A-6D schematically shows steps in an embodiment according to the presently claimed invention, of manufacturing an embodiment according to the presently claimed invention, of a semi-translucent photovoltaic device;
FIG. 7 schematically shows other embodiments according to the presently claimed invention, of a semi-translucent photovoltaic device.

### DETAILED DESCRIPTION OF EMBODIMENTS

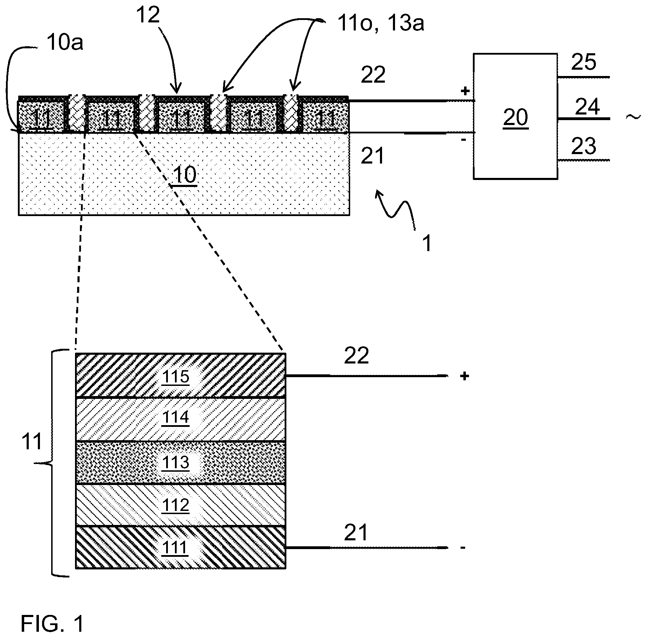

Like reference symbols in the various drawings indicate like elements unless otherwise indicated. It is noted that the embodiments as shown in, and described with reference to Figures 1, 2, Figures 4A-4E and Figures 5A-5C are not encompassed by the wording of the claims but are considered as useful for understanding the invention"

FIG. 1 schematically shows a semi-translucent photovoltaic device 1 that comprises a translucent substrate 10 provided at a first side 10a with a photovoltaic stack 11 which is interrupted by spatially distributed openings 11o. The photovoltaic stack 11 may be coupled with a first and a second electrical connector 21 and 22 to DC/AC convertor 20 which is coupled at its output 23, 24, 25 with a three phase mains net. Alternatively, the photovoltaic stack 11 may be coupled with its electrical connector to a battery charger, or to an electric load for example. As schematically shown in a detailed section of FIG. 1, the photovoltaic stack 11 at least comprises a first electrode 111, a second electrode 115 and a photovoltaic layer 113 between these electrodes. Typically also a charge carrier transport layer is present between each electrode 111, 115 and the photovoltaic layer 113. For example, here an electron transport layer 112 is present between the first electrode 111 (being the cathode) and the photovoltaic layer 113. Also a hole transport layer 114 is present between the second electrode 115 (being the anode) and the photovoltaic layer 113. It is noted that what is indicated as a single layer, may be a stack of sub-layers. For clarity however only a single layer is shown for each function.

A protective layer 12 extends blanket-wise over surface formed by the combination of the substrate 10 and the interrupted photovoltaic stack 11. The spatially distributed openings 11o that interrupt the photovoltaic stack 11 are filled with a translucent polymer 13a obtained from a radiation-cured precursor.

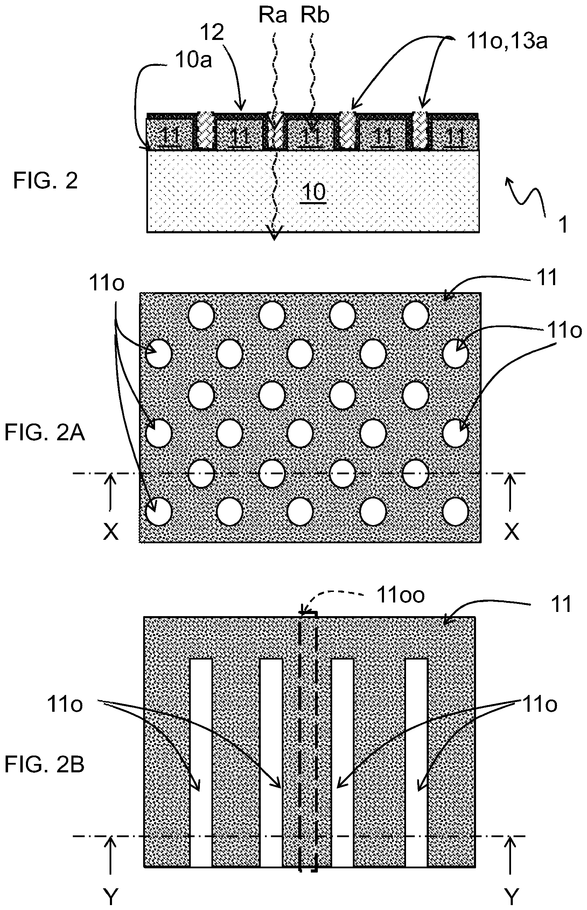

As shown schematically in FIG. 2, the semi-translucent photovoltaic device 1 transmits a portion Ra of incident solar radiation via the translucent polymer 13a in the openings 11o and absorbs another portion Rb into the photovoltaic stack 11 for conversion into electric power.

Various options are possible for providing the translucent regions 11o in the photovoltaic stack 11. In the example shown in FIG. 2A, the openings 11o are circular. However any other shape may be selected, e.g. oval or rectangular. As can be seen in FIG. 2A the surface comprises subsequent rows of openings. The cross-section X-X through the second row from below corresponds to that shown in FIG. 2. All other even rows have the same alignment, and the odd rows are shifted with respect to the even rows.

In the example of FIG. 2B, the openings 11o are provided as mutually parallel rectangular openings. The cross-section Y-Y corresponds to the cross-section shown in FIG. 2. In the embodiments shown in FIG. 2A, 2B, the photovoltaic stack 11 remains as one unit. I.e. although the stack 11 is interrupted by the openings 11o, it is still laterally connected. For each layer in the stack 11, a path is available therein between each pair of points in that layer. Alternatively, the stack may be partitioned into mutually separate photovoltaic stack-sections. For example in the embodiment of FIG. 2B an additional opening 11oo may be provided that partitions the photovoltaic stack 11 in a left connected section and a right connected section. Also in the example of FIG. 2A additional openings may be provided that partitions the photovoltaic stack 11 into sections that are mutually disconnected.

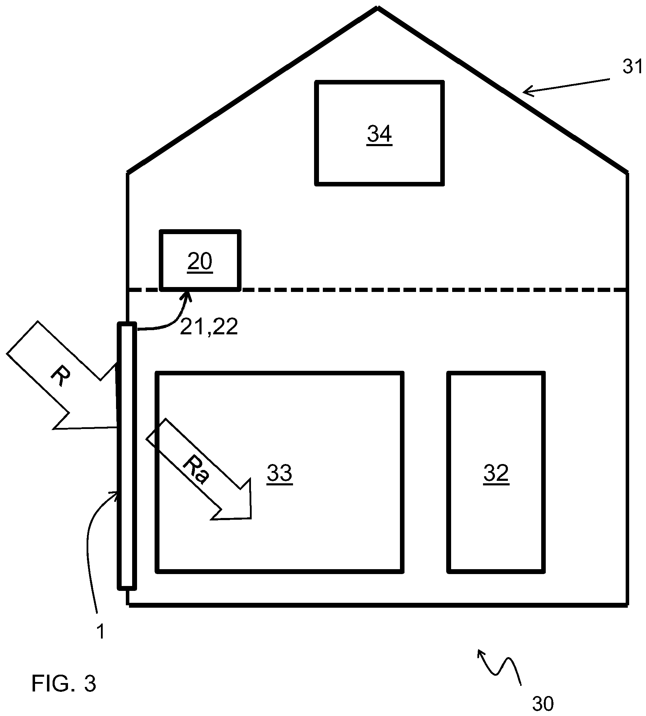

FIG. 3 schematically shows, as an exemplary application, a house 30 having a roof 31, front door 32, windows 33, 34 and further having a semi-translucent photovoltaic device 1 serving as a photovoltaic window in the house 30. The photovoltaic window 1 may be transparent, but may alternatively be opal, or may be controllably switched in either one of a transparent state or an opal state. A portion Ra of solar radiation R impingent on the window 1 is transmitted, and a remaining portion of the solar radiation is absorbed in the semi-translucent photovoltaic device 1 for conversion into electric energy, which is provided via electrical connectors 21, 22 to a DC/AC converter 20 or to a storage device.

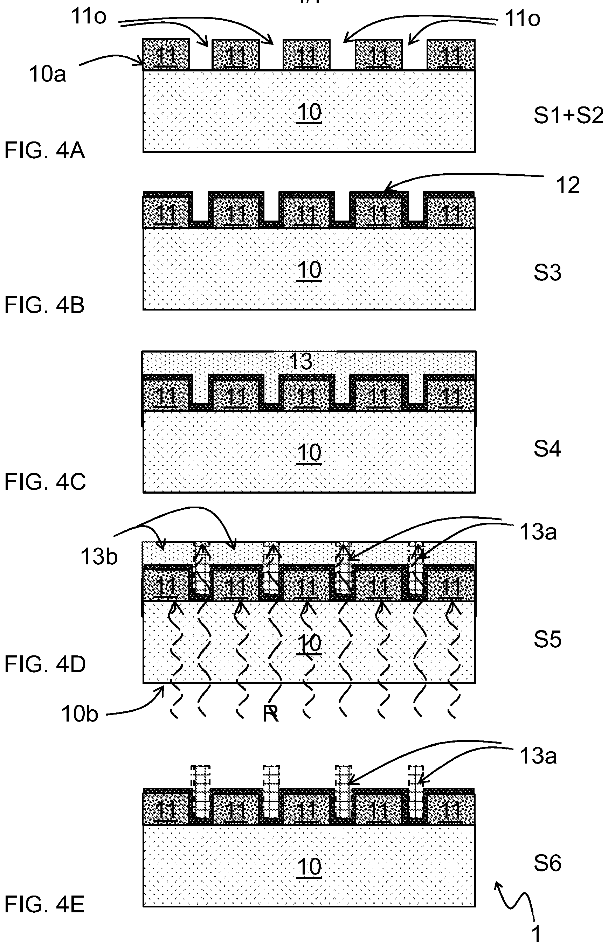

FIG. 4 schematically shows a method of manufacturing a semi-translucent photovoltaic device 1 as shown in FIG. 1, 2, 2A, 2B and as applied for example in the application of FIG. 3.

In step S1, a substrate 10 is provided at a first side 10a with a photovoltaic stack 11. The photovoltaic stack 11 may be provided by subsequent deposition of functional layers. Therewith a selection may be made from various deposition technologies. For example, inorganic layers may be applied by all kinds of vapor deposition methods, e.g. physical vapor deposition methods such as thermal evaporation, e-beam evaporation, sputtering, magnetron sputtering, reactive sputtering, reactive evaporation, etc. and all kinds of chemical vapor deposition methods such as thermal chemical vapor deposition (CVD), photo assisted chemical vapor deposition (PACVD), plasma enhanced chemical vapor deposition (PECVD), etc. Organic layers may be applied by all kinds of coatings techniques, such spin coating, slot-die coating, kiss-coating, hot-melt coating, spray coating, etc. and all kinds of printing techniques, such as inkjet printing, gravure printing, flexographic printing, screen printing, rotary screen printing, etc.

The photovoltaic stack should at least comprises a first electrode layer, a second electrode layer and a photovoltaic layer contacting these both electrode layers. Therewith the photovoltaic layer may be arranged between the first electrode layer and the second electrode layer. The stack can be obtained by subsequent deposition of the first electrode layer, the photovoltaic layer and the second electrode layer. Typically also a charge carrier transport layer is present between each electrode and the photovoltaic layer. In that case a first charge carrier layer is deposited subsequent to depositing the first electrode layer, but before depositing the photovoltaic layer and/or a second charge carrier transport layer is deposited subsequent to depositing the photovoltaic layer, and before depositing the second electrode layer.

Alternatively, both electrode layers may be provided at a same side of the photovoltaic layer, as for example disclosed in PCT-application WO/2018/190711, filed by the same applicant. In that case depositing the stack comprises depositing in the order first electrode layer, insulating layer, second electrode layer and photovoltaic layer, wherein the photovoltaic layer contacts the first electrode layer via openings through the second electrode layer and the insulating layer. Additional layers may be deposited. For example, first charge carrier transport layer may be deposited subsequent to depositing the first electrode layer, but before depositing the insulating layer. Also, for example, a second charge carrier transport layer may be deposited subsequent to depositing the second electrode layer, but before depositing the photovoltaic layer.

Subsequent to step S1, wherein the photovoltaic stack 11 is deposited, in step S2, material is removed from the stack in spatially distributed regions. Therewith openings 11o are formed within these regions that expose the surface at the first side 10a where the stack 11 is deposited.

In step S3, a protective layer 12 is deposited in a blanket-wise manner over the substrate with the photovoltaic stack 11. The protective layer 12 is to protect the materials of the photovoltaic stack later in the method as set out in more detail below. The protective layer 12 may for example be a layer of PTFE, which is provided by a TFE deposition and its subsequent polymerization. Alternatively, an encapsulation layer of a translucent inorganic material like SiN or Al2O3 is suitable for this purpose.

In step S4 a layer 13 of a radiation-curable precursor for the translucent polymer is deposited in a blanket-wise manner over the protective layer 12. The precursor may be a negative photoresist or a crosslinking polymer for example.

In step S5, the substrate 10 is irradiated from a second side 10b opposite its first side 10a. The radiation R protrudes through the openings 10o within the photovoltaic stack 11 and therewith selectively cures the radiation-curable precursor 13 within and in front of these openings 11o. The radiation-curable precursor is exposed to the radiation R transmitted via the openings and therewith is cured into translucent polymer portions 13a. Outside these openings 11o, the radiation is absorbed by the photovoltaic stack 11. Hence the remainder 13b of the material of radiation-curable precursor 13 is not exposed to radiation and remains soluble. The radiation-curable precursor is preferably a visible light curable substance. The material of the photovoltaic layer is typically adapted to absorb visible radiation for photo-electric conversion and the substrate and any layers between the substrate and the photovoltaic layer will typically be adapted to transmit visible light, so that no specific design requirements are imposed to the other materials used in the photovoltaic device. Visible light curable substances are readily available, and for example denoted as visible light curable adhesives. Alternatively, it may be contemplated to use UV-curable substances provided that a photovoltaic material is selected that is opaque to UV-radiation used for curing, and that the substrate and intervening layers transmit the UV-radiation used for this purpose.

In step S6, this remainder 13b is removed by a proper solvent. The photovoltaic stack 11 is therewith protected by the protective layer 12.

One option to control a distribution of incident radiation between a portion to be absorbed for photoelectric conversion by the photovoltaic stack and a portion to be transmitted through the device is the selection of the dimensions and the distribution of the openings 11o in the photovoltaic stack 11. Should it be the case that these specifications are already fixed for other reasons, for example because it is desired to have a common deposition process, other options are available for controlling this distribution.

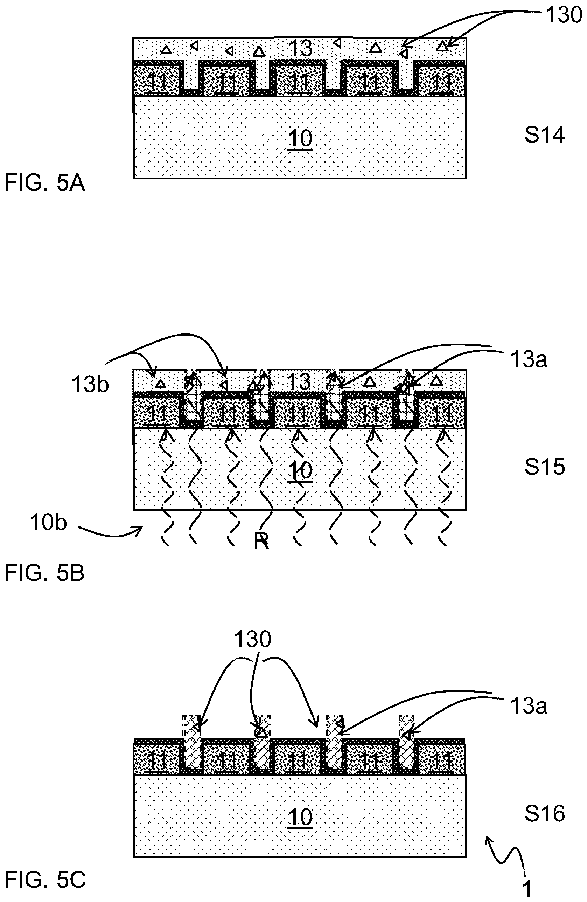

One option is illustrated in FIG. 5A-5C. This option proceeds with the semi-finished product is obtained with steps S1-S3 presented in FIG. 4A, 4B.

Then in step S14, shown in FIG. 5A, a layer 13 of a radiation-curable precursor is deposited, in a manner similar to step S4 in FIG. 4C. However, in this embodiment of the method, the radiation-curable precursor 13 comprises scattering particles 130.

Analogous as in step S5 of FIG. 4D, a step S15, shown in FIG. 5B, is performed wherein the substrate 10 is irradiated from the second side 10b. The radiation R protrudes through the openings 10o within the photovoltaic stack 11 and therewith selectively cures the modified radiation-curable precursor 13 as deposited in step S14 within and in front of these openings 11o.

Further, analogous as in step S6 of FIG. 4D, a step S16, shown in FIG. 5C is performed wherein the remaining uncured precursor 13b is removed by a proper solvent.

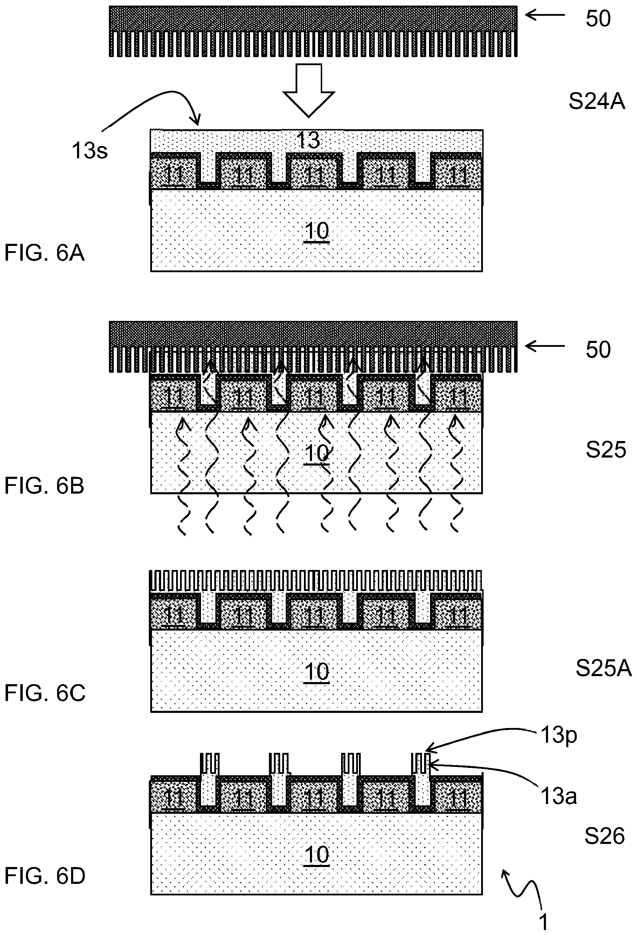

FIG. 6A-6D illustrate an option according to the presently claimed invention to modify the distribution of incident radiation between a portion to be absorbed for photoelectric conversion, and a portion to be transmitted. FIG. 6A shows a semi-finished product according to the presently claimed invention that is obtained with the steps S1-S4, as shown in FIG. 4A-4C.

Subsequently, in an additional step S24A, shown in FIG. 6A, a patterned stamp 50 is moved into a free surface 13s of the layer 13 of the radiation-curable precursor. Step S25 shown in FIG. 6B, corresponds to step S5 of FIG. 4D, however, with the modification that the stamp 50 is maintained at that position, during the irradiation.

As shown in FIG. 6C, after the radiation-curable precursor in layer 13 is selectively cured by the irradiation in step S25, the stamp is removed in the additional step S25A.

Subsequently in step S26, shown in FIG. 6D, and similar to step S6 in FIG. 4E the uncured remainder 13b of the radiation-curable precursor in layer 13 is removed. In the product obtained therewith, shown in FIG. 6D, the translucent polymer portions 13a have a patterned surface 13p, complementary to the pattern of the stamp 50. The pattern 13p changes the distribution of incident radiation into a portion to be absorbed for photoelectric conversion, and a portion to be transmitted. The patterned surface may have a random surface pattern or alternatively a pattern formed of geometric structures, e.g. domes or pyramids.

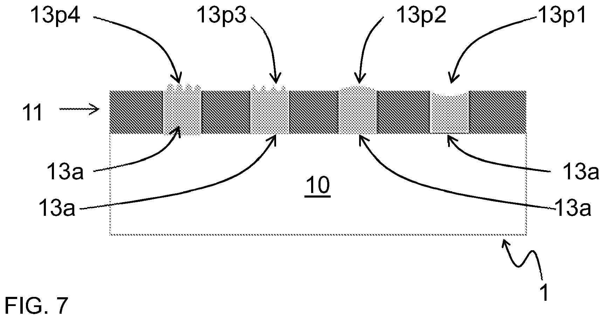

Various other options are available to provide the translucent polymer portions 13a have a patterned surface. Examples 13p1, 13p2, 13p3, 13p4, according to the invention as presently claimed are shown in FIG. 7. In the example shown in FIG. 7, these options are combined in one product 1. Alternatively a single pattern may be applied for one product 1. For example, a pattern 13p1, defining a concave lens may be applied, which tends to diverge incident radiation towards the photovoltaic stack 11, so that a larger proportion of the incident radiation is available for photovoltaic conversion. The same effect is achieved with the pattern 13p3, which comprises a diverging Fresnel lens. Alternatively, a pattern 13p2, defining a convex lens may be applied, which tends to converge incident radiation within the polymer portions 13a, so that a larger proportion of the incident radiation is transmitted through the product 1. The same effect is achieved with the pattern 13p4, which comprises a converging Fresnel lens.

It is noted that various options are available for selecting the materials from which the photovoltaic stack is to be composed. For example various photovoltaic materials are available including inorganic, i.e. silicon based materials and organic materials. A very promising category of materials for this purpose are perovskites. Perovskites typically have a crystal structure of ABX3, wherein A is an organic cation as methylammonium (CH3NH3)+, B is an inorganic cation, usually lead (II) (Pb2+), and X is a halogen atom such as iodine (I-), chlorine (Cl-), fluorine (F-) or bromine (Br-). Perovskites are particularly advantageous in that they can be processed relatively easily and in that their bandgap can be set to a desired value by a proper choice of the halide content. One of examples is methylammonium lead trihalide (CH3NH3PbX3), with an optical bandgap between 1.5 and 2.3 eV depending on halide content. Other more complex structures contain mixed A cations, such as Cesium (Cs+), methylammonium ((CH3NH3)+, MA), formamidinum ((H2NCHNH2)+, FA), or rubidium (Rb+) and mixed X anions. The examples of complex mixed perovskites are Cesium formamidinum lead trihalide CsxFA1-xPbIyBr3-y and Cesium Methylamonium formamidinum lead trihalide CsxMAzFA1-x-zPbIyBr3-y (where x<1, z<1, x+z<1). With the A-cations and X-anions ratio the bandgap and the physical properties of perovskite materials can be tuned. Other metals such as tin may replace the role of Pb in the B position of perovskite materials. An example thereof is CH3NH3SnI3. Also combinations of Sn with Pb perovskites having a wider bandgap in the range of 1.2 to 2.2 eV are possible. A perovskite photovoltaic layer 43 may have a thickness in the range of 100 nm to 20 micron for example.

The photovoltaic stack 11 may be one of a stack of stacks. For example, the stack of stacks may comprises a pair of a first and a second perovskite based photovoltaic stack (e.g. a PSC-PSC tandem), wherein the first and the second perovskite based photovoltaic stack convert respective mutually different portions of the radiation spectrum into electric power.

Regarding the electrode layers, the following may be contemplated. As it is not necessary that the photovoltaic stack is translucent, it is sufficient that only the electrode layer facing the side from which the solar radiation is received is translucent. The other electrode layer may be opaque. For example, if the product of FIG. 1 is to receive radiation from above, then it is sufficient that the electrode layer 115 is translucent and electrode layer 111 may be opaque. If on the other hand, the product of FIG. 1 is to receive radiation from below, then it is sufficient that the electrode layer 111 is translucent and electrode layer 115 may be opaque.

Examples of organic translucent (transparent) electrically conductive materials, suitable for use in a translucent electrode layer, are polyaniline, polythiophene, polypyrrole or doped polymers. Examples of inorganic translucent (transparent) electrically conductive materials suitable for use in a translucent electrode layer are ITO (Indium Tin Oxide), IZO (Indium Zinc Oxide), ATO (Antimony Tin Oxide), or Tin Oxide can be used. Other metal oxides can work, including but not limited to Nickel-Tungsten-Oxide, Indium doped Zinc Oxide, Magnesium-Indium-Oxide. Also (combinations of) a thin metal layer, an oxide layer, or other e.g. a TCO or a metal oxide layer or a conducting polymer layer, such as PEDOT-PSS may be used.. For example a 7 nm layer of Silver may be sandwiched in between two 10 nm ITO layers. The transparent electrically conductive electrode layer may have a total thickness in the range of a few tens of nm to a few hundreds of nm, for example in a range between 100 and 200 nm, for example about 120 nm. In some embodiments a translucent electrode layer may be supported, for example by a mesh of an electrically conductive material that is in electric contact with the translucent electrode layer, or by transverse electrical conductors that extend from a conductive plane, via transverse conductors through the photovoltaic layer towards the translucent electrode layer.

For an electrode layer which is not necessarily translucent also other electrically conductive materials would be suitable. For example metal layer, e.g. from copper or silver, having an arbitrary thickness, would be applicable.

As noted above, one or more charge carrier transport layers may be provided. For example a hole transport layer, here the charge carrier transport layer 112, such as a nickel-oxide layer or a MoSe layer, may be provided between the anode (here layer 111) and the photovoltaic layer 113. Further examples of hole transport materials for a hole transport layer have been summarized for example, in Kirk-Othmer Encyclopedia of Chemical Technology, Fourth Edition, Vol. 18, p. 837-860, 1996, by Y. Wang. Both hole transporting molecules and polymers can be used. In an embodiment a hole transport layer may have a thickness in the range of 10 to 200 nm. Additionally, an electron transport layer here the layer 114 may be provided between the cathode (here 115) and the photovoltaic layer 113. Suitable materials for this purpose are for example TiO2, SnO2, ZrO2 and ZnO: The electron transport layer may have a thickness in the range of a few nm to a few hundreds of nm.

Depending on the application, the substrate may for example be a glass or a polymer like PET, PEN. Also dependent on the application the substrate may have a thickness of some tens of micron to a few mm.

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

Also, use of the "a" or "an" are employed to describe elements and components of the invention. This is done merely for convenience and to give a general sense of the invention. This description should be read to include one or at least one and the singular also includes the plural unless it is obvious that it is meant otherwise.

## Claims

1. Method of manufacturing a semi-translucent photovoltaic device (1), comprising a translucent substrate (10) with a photovoltaic stack (11) interrupted in spatially distributed openings (11o) filled with a translucent polymer (13a), the method comprising:
- providing (S1) the substrate (10) at a first side (10a) with the photovoltaic stack (11);
- removing (S2) material from the stack in spatially distributed regions, therewith forming openings (11o) within these regions;
- blanket-wise depositing (S4) a layer (13) of a radiation-curable precursor for the translucent polymer over the protective layer (12);
- irradiating (S5) the substrate (10) from a second side (10b) opposite its first side (10a) to therewith selectively cure the radiation-curable precursor within and in front of the spatially distributed openings (11o), the radiation-curable precursor being converted therewith into said translucent polymer (13a); **characterized by**
- blanket-wise depositing (S3) a protective layer (12) over the substrate with the photovoltaic stack (11), subsequent to said removing (S2) material from the stack and preceding said blanket-wise depositing (S4) a layer (13) of a radiation-curable precursor;
- moving (S24A) a patterned stamp (50) into a free surface (13s) of the layer (13) of the radiation-curable precursor, before the step of irradiating (S25), and removing (S25A) the stamp subsequent to said irradiating (S25)
- removing (S6) an uncured remainder (13b) of the layer of the radiation-curable precursor..

2. The method according to claim 1, wherein the layer (13) of a radiation-curable precursor comprises scattering particles (130).

3. The method according to claim 1 or 2, wherein the stamp (50) is patterned to imprint a scattering structure into said free surface (13s).

4. The method according to claim 1 or 2, wherein the stamp (50) is patterned to imprint lens-like elements (13p1, 13p2, 13p3, 13p4) in the free surface which are aligned with the photovoltaic cells to direct light thereto.

5. A semi-translucent photovoltaic device (1), comprising a translucent substrate (10) with a photovoltaic stack (11) which is interrupted by spatially distributed openings (11o), comprising:
- a substrate (10) provided at a first side (10a) with said photovoltaic stack (11);
- the spatially distributed openings (11o) being filled with a translucent polymer (13a) obtained from a radiation-cured precursor,
**characterized in that**
a protective layer (12) extends blanket-wise over the substrate (10) with said photovoltaic stack (11);
a free surface (13s) of the filling of the translucent polymer (13a) is patterned.

6. The photovoltaic device according to claim 5, wherein the translucent polymer (13a) comprises scattering particles (130).

7. The photovoltaic device according to claim 5 or 6, wherein the free surface (13s) of the filling of the translucent polymer (13a) is patterned as a scattering structure.

8. The photovoltaic device according to claim 5 or 6, wherein the free surface (13s) of the filling of the translucent polymer (13a) has a pattern of lens-like elements.

9. The photovoltaic device according to claim 8, wherein the lens-like elements are concave lenses (13p 1).

10. The photovoltaic device according to claim 8, wherein the lens-like elements are convex lenses (13p2).

11. The photovoltaic device according to claim 8, wherein the lens-like elements are diverging Fresnel lenses (13p3).

12. The photovoltaic device according to claim 8, wherein the lens-like elements are converging Fresnel lenses (13p4).

13. The photovoltaic device according to one of the claims 5-12, wherein the photovoltaic stack (11) comprise a perovskite photovoltaic layer.

## Patentansprüche

1. Verfahren zur Herstellung einer halbdurchsichtigen fotovoltaischen Vorrichtung (1), die ein durchsichtiges Substrat (10) mit einem Fotovoltaik-Stapel (11) umfasst, der von räumlich verteilten Öffnungen (11o) unterbrochen ist, die mit einem durchsichtigen Polymer (13a) gefüllt sind, wobei das Verfahren umfasst:
- Versehen (S1) des Substrats (10) auf einer ersten Seite (10a) mit dem Fotovoltaik-Stapel (11);
- Entfernen (S2) von Material vom Stapel in räumlich verteilten Regionen, um damit Öffnungen (11o) innerhalb dieser Regionen zu bilden;
- flächendeckendes Abscheiden (S4) einer Schicht (13) eines durch Strahlung härtbaren Vorläufers für das durchsichtige Polymer über die Schutzschicht (12);
- Bestrahlen (S5) des Substrats (10) von einer zweiten Seite (10b) gegenüber seiner ersten Seite (10a), um damit den durch Strahlung härtbaren Vorläufer selektiv innerhalb und vor den räumlich verteilten Öffnungen (11o) zu härten, wodurch das durch Strahlung härtbare Polymer in das durchsichtige Polymer (13a) umgewandelt wird;
**gekennzeichnet durch**
- flächendeckendes Abscheiden (S3) einer Schutzschicht (12) über das Substrat mit dem Fotovoltaik-Stapel (11) nach dem Entfernen (S2) des Materials vom Stapel und vor dem flächendeckenden Abscheiden (S4) einer Schicht (13) eines durch Strahlung härtbaren Vorläufers;
- Bewegen (S24A) eines strukturierten Stempels (50) in die freie Oberfläche (13s) der Schicht (13) des durch Strahlung härtbaren Vorläufers vor dem Schritt des Bestrahlens (S25) und Entfernen (S25A) des Stempels nach dem Bestrahlen (S25),
- Entfernen (S6) eines ungehärteten Rests (13b) der Schicht des durch Strahlung härtbaren Vorläufers.

2. Verfahren nach Anspruch 1, wobei die Schicht (13) eines durch Strahlung härtbaren Vorläufers Streuteilchen (130) umfasst.

3. Verfahren nach Anspruch 1 oder 2, wobei der Stempel (50) so strukturiert ist, dass er eine Streustruktur in die freie Oberfläche (13s) einprägt.

4. Verfahren nach Anspruch 1 oder 2, wobei der Stempel (50) so strukturiert ist, dass er linsenartige Elemente (13p 1, 13p2, 13p3, 13p4) in die freie Oberfläche einprägt, die auf die fotovoltaische Zellen ausgerichtet sind, um Licht darauf zu richten.

5. Halbdurchsichtige fotovoltaische Vorrichtung (1), umfassend ein durchsichtiges Substrat (10) mit einem Fotovoltaik-Stapel (11), der von räumlich verteilten Öffnungen (11o) unterbrochen ist, umfassend:
- ein Substrat (10), das auf einer ersten Seite (10a) mit dem Fotovoltaik-Stapel (11) versehen ist;
- die räumlich verteilten Öffnungen (11o), die mit einem durchsichtigen Polymer (13a) gefüllt sind, das aus einem durch Strahlung härtbaren Vorläufer erhalten wird,
**dadurch gekennzeichnet, dass**
eine Schutzschicht (12) sich flächendeckend über das Substrat (10) mit dem Fotovoltaik-Stapel (11) erstreckt;
eine freie Oberfläche (13s) der Füllung des durchsichtigen Polymers (13a) strukturiert ist.

6. Fotovoltaische Vorrichtung nach Anspruch 5, wobei das durchsichtige Polymer (13a) Streuteilchen (130) umfasst.

7. Fotovoltaische Vorrichtung nach Anspruch 5 oder 6, wobei die freie Oberfläche (13s) der Füllung des durchsichtigen Polymers (13a) als eine Streustruktur strukturiert ist.

8. Fotovoltaische Vorrichtung nach Anspruch 5 oder 6, wobei die freie Oberfläche (13s) der Füllung des durchsichtigen Polymers (13a) eine Struktur linsenartiger Elemente aufweist.

9. Fotovoltaische Vorrichtung nach Anspruch 8, wobei die linsenartigen Elemente konkave Linsen (13p1) sind.

10. Fotovoltaische Vorrichtung nach Anspruch 8, wobei die linsenartigen Elemente konvexe Linsen (13p2) sind.

11. Fotovoltaische Vorrichtung nach Anspruch 8, wobei die linsenähnlichen Elemente divergierende Fresnel-Linsen (13p3) umfassen.

12. Fotovoltaische Vorrichtung nach Anspruch 8, wobei die linsenartigen Elemente konvergierende Fresnel-Linsen (13p4) sind.

13. Fotovoltaische Vorrichtung nach einem der Ansprüche 5 bis 12, wobei der Fotovoltaik-Stapel (11) eine Perowskit-Fotovoltaik-Schicht umfasst.

## Revendications

1. Procédé de fabrication d'un dispositif photovoltaïque semi-translucide (1), comprenant un substrat translucide (10) avec un empilement photovoltaïque (11) coupé par des ouvertures réparties spatialement (11o) remplies d'un polymère translucide (13a), le procédé comprenant les étapes consistant à :
- disposer (S1) le substrat (10) au niveau d'un premier côté (10a) avec l'empilement photovoltaïque (11) ;
- retirer (S2) du matériau depuis l'empilement dans des régions réparties spatialement, en formant ainsi des ouvertures (11o) à l'intérieur de ces régions ;
- déposer par recouvrement (S4) une couche (13) d'un précurseur durcissable par rayonnement, pour le polymère translucide, sur la couche protectrice (12) ;
- irradier (S5) le substrat (10) à partir d'un second côté (10b), opposé à son premier côté (10a), afin de durcir sélectivement le précurseur durcissable par rayonnement à l'intérieur et à l'avant des ouvertures réparties spatialement (11o), le précurseur durcissable par rayonnement étant ainsi converti en ledit polymère translucide (13a) ;
**caractérisé par** :
déposer par recouvrement (S3) une couche protectrice (12) sur le substrat avec l'empilement photovoltaïque (11), après ladite élimination (S2) de matériau depuis l'empilement et avant ledit dépôt par recouvrement (S4) d'une couche (13) d'un précurseur durcissable par rayonnement ;
déplacer (S24A) une estampille configurée (50) dans une surface libre (13s) de la couche (13) du précurseur durcissable par rayonnement, avant l'étape d'irradiation (S25), et retirer (S25A) l'estampille après ladite irradiation (S25)
retirer (S6) un reste non durci (13b) de la couche du précurseur durcissable par rayonnement.

2. Procédé selon la revendication 1, dans lequel la couche (13) d'un précurseur durcissable par rayonnement comprend des particules de diffusion (130).

3. Procédé selon la revendication 1 ou 2, dans lequel l'estampille (50) est configurée pour imprimer une structure de diffusion dans ladite surface libre (13s).

4. Procédé selon la revendication 1 ou 2, dans lequel l'estampille (50) est configurée pour imprimer des éléments de type lentille (13p1, 13p2, 13p3, 13p4) dans la surface libre qui sont alignés avec les cellules photovoltaïques pour diriger la lumière vers celles-ci.

5. Dispositif photovoltaïque semi-translucide (1), comprenant un substrat translucide (10) avec un empilement photovoltaïque (11) qui est coupé par des ouvertures réparties spatialement (11o), comprenant :
- un substrat (10) disposé au niveau d'un premier côté (10a) dudit empilement photovoltaïque (11) ;
- les ouvertures réparties spatialement (11o) étant remplies d'un polymère translucide (13a) obtenu à partir d'un précurseur durci par rayonnement,
**caractérisé en ce que**
une couche protectrice (12) s'étend d'une manière par recouvrement sur le substrat (10) avec ledit empilement photovoltaïque (11) ;
une surface libre (13s) du remplissage du polymère translucide (13a) est configurée.

6. Dispositif photovoltaïque selon la revendication 5, dans lequel le polymère translucide (13a) comprend des particules de diffusion (130).

7. Dispositif photovoltaïque selon la revendication 5 ou 6, dans lequel la surface libre (13s) du remplissage du polymère translucide (13a) est configurée comme une structure de diffusion.

8. Dispositif photovoltaïque selon la revendication 5 ou 6, dans lequel la surface libre (13s) du remplissage du polymère translucide (13a) présente une configuration d'éléments de type lentille.

9. Dispositif photovoltaïque selon la revendication 8, dans lequel les éléments de type lentille sont des lentilles concaves (13p1).

10. Dispositif photovoltaïque selon la revendication 8, dans lequel les éléments de type lentille sont des lentilles convexes (13p2).

11. Dispositif photovoltaïque selon la revendication 8, dans lequel les éléments de type lentille sont des lentilles de Fresnel divergentes (13p3).

12. Dispositif photovoltaïque selon la revendication 8, dans lequel les éléments de type lentille sont des lentilles de Fresnel convergentes (13p4).

13. Dispositif photovoltaïque selon l'une quelconque des revendications 5 à 12, dans lequel l'empilement photovoltaïque (11) comprend une couche photovoltaïque de pérovskite.
